# EUROPEAN PATENT APPLICATION

(11) **EP 2 093 880 A1**
(43) Date of publication of application: **26.08.2009**
(21) Application number: 07830428.4
(22) Date of filing: 24.10.2007
(51) Int. Cl.: H03H 9/145, H03H 9/25

(54) **SURFACE ACOUSTIC WAVE RESONATOR AND SURFACE ACOUSTIC WAVE DEVICE**

(30) Priority: 29.11.2006 JP 2006321659
(71) Applicant: Murata Manufacturing Co. Ltd., Nagaokakyo-shi, Kyoto 617-8555 (JP)
(72) Inventor: KIDOH, Hideo, Nagaokakyo-shi Kyoto 617-8555 (JP)
(74) Representative: Thévenet, Jean-Bruno
(86) International application number: PCT/JP2007/070694
(87) International publication number: WO 2008/065834

(57) **Abstract**

A low-loss surface acoustic wave resonator which is less affected by spurious responses over a wider temperature range and in which the IDT electrode is protected by formation of a SiO₂ film is provided. A surface acoustic wave resonator (1) includes a rotated Y-cut quartz substrate (2) with a cut angle θ of -53° to -52° and an IDT electrode (3) composed of aluminum or an alloy mainly composed of aluminum formed on the quartz substrate. The propagation direction of surface acoustic waves is within the range of 90° ±5° with respect to the X axis. A SiO₂ film (6) covers the quartz substrate (2) and the IDT electrode (3). The thickness of the IDT electrode (3) is in the range of 6.0% to 6.5% of λ, where λ is the wavelength of surface acoustic waves, and the duty ratio of the IDT electrode (3) is in the range of 0.62 to 0.66.

## Description

### Technical Field

The present invention relates to surface acoustic wave resonators including quartz substrates. In particular, it relates to a surface acoustic wave resonator in which a SiO₂ film covers an IDT electrode, and a surface acoustic wave device including such a surface acoustic wave resonator.

### Background Art

Surface acoustic wave devices are widely used in cellular phones and parts of vehicle-mountable electronic appliances. A surface acoustic wave device includes a piezoelectric substrate and an IDT electrode formed on the piezoelectric substrate. Various piezoelectric single crystals and piezoelectric ceramics are used as the materials for forming the piezoelectric substrate.

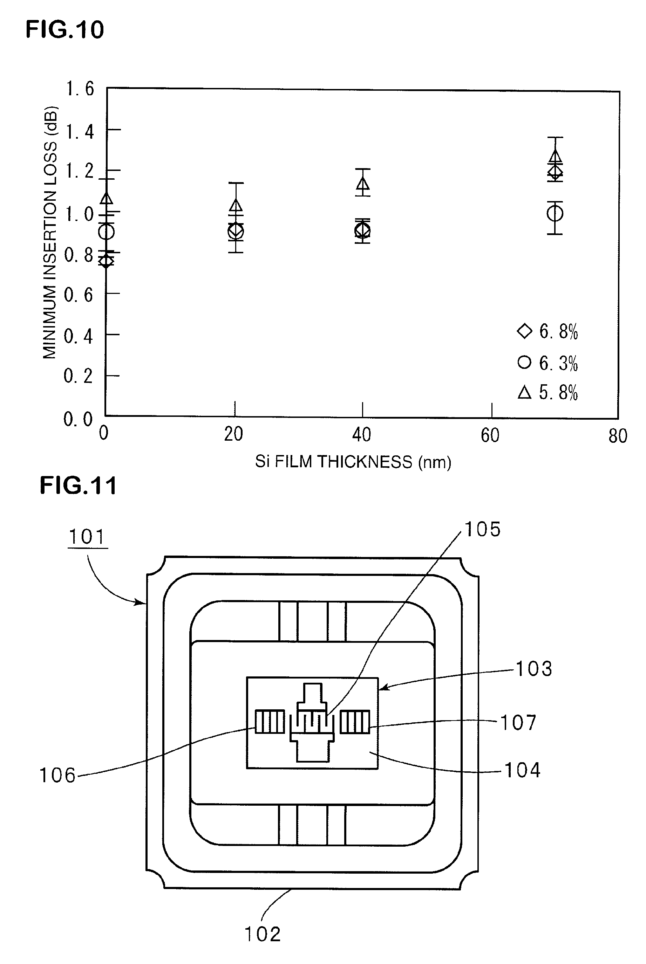

Patent Document 1 below describes a surface acoustic wave device having an IDT electrode composed of Al or an alloy mainly composed of Al on a quartz substrate. Fig. 11 is a cross-sectional view schematically showing a surface acoustic wave device described in Patent Document 1.

A surface acoustic wave device 101 has a packaging member 102 having an opening that opens upward. A surface acoustic wave resonator 103 is disposed in the opening. In other words, the surface acoustic wave resonator 103 is mounted on a bottom surface inside the opening of the packaging member 102.

The surface acoustic wave resonator 103 has a rotated Y-cut quartz substrate 104 with a cut angle θ of -64.0° < θ < -49.3°. On the quartz substrate 104 lie an IDT electrode 105 and reflectors 106 and 107 disposed at the two sides of the IDT electrode 105 in the surface acoustic wave propagation direction. The IDT electrode 105 is disposed so that the surface acoustic wave propagation direction is 90° with respect to the X axis. The IDT electrode 105 and the reflectors 106 and 107 are composed of aluminum and have a thickness of 0.04λ to 0.12λ, where λ is the wavelength of the surface acoustic waves. The duty ratio of the IDT electrode 105 is set to 0.5 to 0.65.

The opening in the surface acoustic wave device 101 in which the surface acoustic wave resonator 103 is housed is covered with a cover member (not shown in the drawing) to hermetically seal the surface acoustic wave resonator 103.

The surface acoustic wave device 101 can have a lower capacity ratio to enhance frequency controllability by setting the cut angle θ of the quartz substrate 104 within the above-described specific range and adjusting the thickness and the duty ratio of the IDT electrode within the above-described specific ranges.

Patent Document 1 also teaches that a protective film composed of a SiO₂ film or a protective film composed of anodized aluminum may be formed to cover the IDT electrode.

The related art section of Patent Document 2 described below discloses that aluminum and alloys mainly composed of aluminum are widely used as materials for forming IDT electrodes of surface acoustic wave devices. Patent Document 2 refers to problems that arise in this type of surface acoustic wave devices. The problems are generation of a transverse mode caused by the IDT serving as a waveguide and generation of ripples caused by the transverse mode in the pass band. The invention set forth in Patent Document 2 offers a structure that can reduce the transverse mode ripple. In particular, an IDT electrode composed of an electrode having a larger load effect than aluminum is formed on a quartz substrate, and the metallization ratio d and the normalized thickness h/λ of the IDT are controlled to reduce the transverse mode ripple to 0.5 dB or less, where metallization ratio of the IDT electrode is represented by d and the electrode thickness is represented by h. In other words, the document shows that the transverse mode ripple can be suppressed by forming an IDT electrode with an electrode material, such as tantalum, having a mass larger than that of aluminum on a quartz substrate and by adjusting the metallization ratio d and the electrode thickness h of the IDT electrode in the specific ranges.
Patent Document 1: Japanese Unexamined Patent Application Publication No. 2006-165746
Patent Document 2: Japanese Unexamined Patent Application Publication No. 2002-135077

### Disclosure of Invention

Patent Document 1 describes that the surface acoustic wave device 101 may include a protective film composed of SiO₂ or anodized aluminum for protecting the IDT electrode. However, it has been found that, regarding the surface acoustic wave device described in Patent Document 1, if a SiO₂ protective film covering the IDT electrode is actually formed on a quartz substrate, considerably large spurious responses are generated between the resonance frequency and antiresonance frequency.

In a surface acoustic wave device described in Patent Document 2, an IDT electrode is formed of an electrode material having a mass load effect larger than that of aluminum and the metallization ratio d of the IDT electrode and the normalized thickness of the IDT electrode are adjusted within specific ranges, as described above, to suppress the transverse mode spurious responses. However, Patent Document 2 does not describe formation of a protective film composed of SiO₂. In other words, the configuration described in Patent Document 2 is designed to suppress transverse mode spurious responses in a surface acoustic wave device that includes a quartz substrate having no SiO₂ film and an IDT electrode composed of aluminum on the substrate. In sum, the way to suppress spurious responses whose exact cause is unknown and which occur when a SiO₂ protective film is formed in a surface acoustic wave device having an aluminum IDT electrode described in Patent Document 1 has not been known in the past.

Under the circumstances of the related art described above, an object of the present invention is to provide a surface acoustic wave resonator including a quartz substrate serving as a piezoelectric substrate, an IDT electrode composed of aluminum or an alloy mainly composed of aluminum on the quartz substrate, and a protective film including a SiO₂ film, in which spurious responses that occur when a protective film formed of a SiO₂ film is provided can be effectively suppressed and thus good frequency characteristics can be achieved. The object is also to provide a surface acoustic wave device including the surface acoustic wave resonator.

A surface acoustic wave resonator of the present invention includes a rotated Y-cut quartz substrate with a cut angle θ of -53° to -52°, an IDT electrode formed on a main surface of the quartz substrate, the IDT electrode being composed of aluminum or an alloy mainly composed of aluminum, and a SiO₂ film covering the main surface of the quartz substrate and the IDT electrode, in which a propagation direction of surface acoustic waves is within the range of 90° ±5° with respect to the X axis, a thickness of the IDT electrode is in the range of 6.0% to 6.5% of λ, where λ is the wavelength of surface acoustic waves propagating in the quartz substrate, and a duty ratio of the IDT electrode is in the range of 0.62 to 0.66.

Preferably, the thickness of the SiO₂ film is in the range of 20 to 70 nm. A surface acoustic wave device of the present invention includes the surface acoustic wave resonator configured according to the present invention and a packaging member that hermetically seals the surface acoustic wave resonator. In the surface acoustic wave device of the present invention, the packaging member preferably includes a package main body having an opening in which the surface acoustic wave resonator is housed, and a cover installed to close the opening of the package main body, the surface of the cover being coated with a conductive material. In such a case, even when part of the conductive coating of the cover scatters and the conductive material constituting the conductive coating scatters toward the surface acoustic wave resonator-side in assembling the package, fluctuations of characteristics caused by deposition of the conductive material and short circuits are suppressed since the IDT electrode is covered with the SiO₂ film. Accordingly, spurious responses that occur when the SiO₂ film is formed can be suppressed, degradation of the insertion loss can be suppressed, and a surface acoustic wave device with high reliability can be provided.

### (Advantages)

A surface acoustic wave resonator of the present invention includes a rotated Y-cut quartz substrate with a cut angle θ of -53° to -52°, an IDT electrode formed on a main surface of the quartz substrate, the IDT electrode being composed of aluminum or an alloy mainly composed of aluminum, and a SiO₂ film covering the main surface of the quartz substrate and the IDT electrode. In this resonator, the propagation direction of surface acoustic waves is within the range of 90° ±5° with respect to the X axis, the thickness of the IDT electrode is in the range of 6.0% to 6.5% of the wavelength of surface acoustic waves, and the duty ratio is in the range of 0.62 to 0.66. Thus, spurious responses whose exact cause is unknown and which occur at a high temperature of about 85°C to 125°C when the SiO₂ film is provided can be effectively suppressed, and degradation of the insertion loss can also be suppressed. Thus, a highly reliable, low-loss surface acoustic wave resonator in which spurious responses do not readily occur in a wide temperature range of -40°C to 125°C, for example, can be provided. Thus, the surface acoustic wave resonator of the present invention is suitable as a resonator for use in a wide temperature range, e.g., an oscillator of a key-less entry system for automobiles and a resonator of a tire-pressure monitoring system.

### Brief Description of Drawings

[Fig. 1] Fig. 1(a) is a front cross-sectional view of a surface acoustic wave resonator according to one embodiment of the present invention; Fig. 1(b) is a schematic plan view showing an electrode structure.
[Fig. 2] Fig. 2 is a partial cut-away perspective view of a surface acoustic wave device containing the surface acoustic wave resonator of the embodiment shown in Fig. 1.
[Fig. 3] Fig. 3 is a graph showing the transmission characteristic and phase characteristic for describing spurious responses at normal temperature when the thickness of the IDT electrode composed of aluminum is as thick as 7.8% of the wavelength of the surface waves.
[Fig. 4] Fig. 4 is a graph showing the relationship between the thickness of the IDT electrode composed of aluminum and the insertion loss.
[Fig. 5] Fig. 5 is a graph showing the transmission characteristics at -40°C, 25°C, and 125°C of a surface acoustic wave resonator in which the thickness of the IDT electrode composed of aluminum is 6.8% of the wavelength of the surface waves and no SiO₂ film is provided.
[Fig. 6] Fig. 6 is a graph showing the transmission characteristics at -40°C, 25°C, and 125°C of a surface acoustic wave resonator in which the thickness of the IDT electrode composed of aluminum is 6.8% of the wavelength of the surface waves and the thickness of the SiO₂ film is 40 nm.
[Fig. 7] Fig. 7 is a graph showing the transmission characteristics at -40°C, 25°C, and 125°C of a surface acoustic wave resonator according to one embodiment of the present invention, in which the thickness of the IDT electrode composed of aluminum is 6.3% of the wavelength of the surface waves, the duty ratio is 0.64, and the thickness of the SiO₂ film is 40 nm.
[Fig. 8] Fig. 8 is a graph showing changes in insertion loss with changes in thickness of the IDT electrode composed of aluminum when the thickness of the SiO₂ film is 40 nm and the duty ratio of the IDT electrode is 0.59.
[Fig. 9] Fig. 9 is a graph showing changes in minimum insertion loss with changes in duty ratio of the IDT electrode when the thickness of the IDT electrode is 6.3% of the wavelength of surface waves and the thickness of the SiO₂ film is 40 nm.
[Fig. 10] Fig. 10 is graph showing the relationship between the thickness of the SiO₂ film and the minimum insertion loss when the thickness of the IDT electrode is 5.8%, 6.3%, or 6.8%.
[Fig. 11] Fig. 11 is a front view of one example of a surface acoustic wave device of related art.

### Reference Numerals

- 1: surface acoustic wave resonator
- 2: quartz substrate
- 3: IDT electrode
- 4, 5: reflector
- 6: SiO₂ film
- 10: surface acoustic wave device
- 11: package main body
- 11a: opening
- 11b, 11c: step
- 12: cover
- 13a to 13c: electrode land
- 14a to 14c: electrode land
- 15: bonding wire

### Best Modes for Carrying Out the Invention

The present invention will now be described by way of specific embodiments with reference to the drawings.

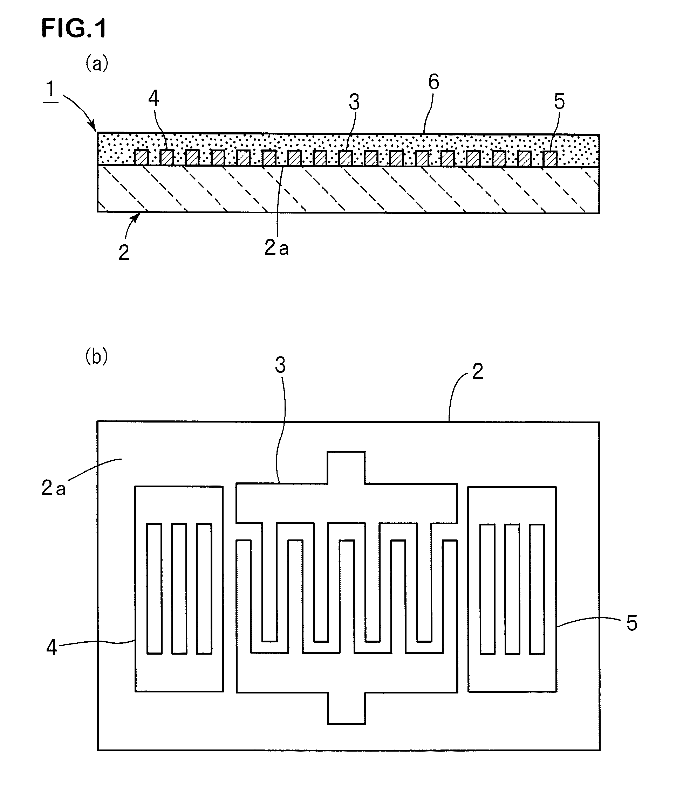

Fig. 1(a) is a front cross-sectional view of a surface acoustic wave resonator according to one embodiment of the present invention and Fig. 1(b) is a schematic plan view showing an electrode structure.

A surface acoustic wave resonator 1 includes a quartz substrate 2. The quartz substrate 2 is a rotated Y-cut quartz substrate with a cut angle θ of -53° to -52°.

On the quartz substrate 2 lie an IDT electrode 3 and reflectors 4 and 5 respectively disposed at the two sides of the IDT electrode 3 in the surface acoustic wave propagation direction. An electrode structure constituted by the IDT electrode 3 and the reflectors 4 and 5 is composed of aluminum. Alternatively, an alloy mainly composed of aluminum may be used instead of aluminum. An "alloy mainly composed of aluminum" refers to an aluminum-based alloy whose aluminum content is 50 percent by weight or more.

The thickness of the IDT electrode 3 is set in the range of 6.0 to 6.5% of the wavelength λ, i.e., the wavelength of oscillated surface acoustic waves. The duty ratio is set in the range of 0.62 to 0.66.

A SiO₂ film 6 is formed on an upper surface of the quartz substrate 2 by covering the IDT electrode 3. The SiO₂ film 6 serves as a protective film that insulates and covers the IDT electrode 3 and the reflectors 4 and 5. The surface acoustic wave resonator 1 is housed in a packaging member and hermetically sealed as with a surface acoustic wave device 10 described below, for example. During assembly of the surface acoustic wave device, if conductive powder and the like scatter from the materials constituting other components and land on the IDT electrode, the characteristics may fluctuate and short-circuits may occur. The SiO₂ film 6 is formed to serve as a protective film for preventing such characteristics fluctuation and short-circuits.

To provide protection, the thickness of the SiO₂ film is preferably about 20 to 70 nm when the surface acoustic wave resonator 1 is used in the 100 to 800 MHz band, for example. A SiO₂ film having a thickness less than 20 nm may not exhibit a protective effect for preventing the short circuits. At a thickness exceeding 70 nm, the insertion loss tends to increase due to the mass load of the SiO₂ film.

The inventor of the present invention has found that when the SiO₂ film is provided, although spurious responses do not occur in the characteristics curves at normal temperatures, large spurious responses arise between the resonance point and the antiresonance point at a temperature around 125°C. This finding is described below by referring to specific experimental examples.

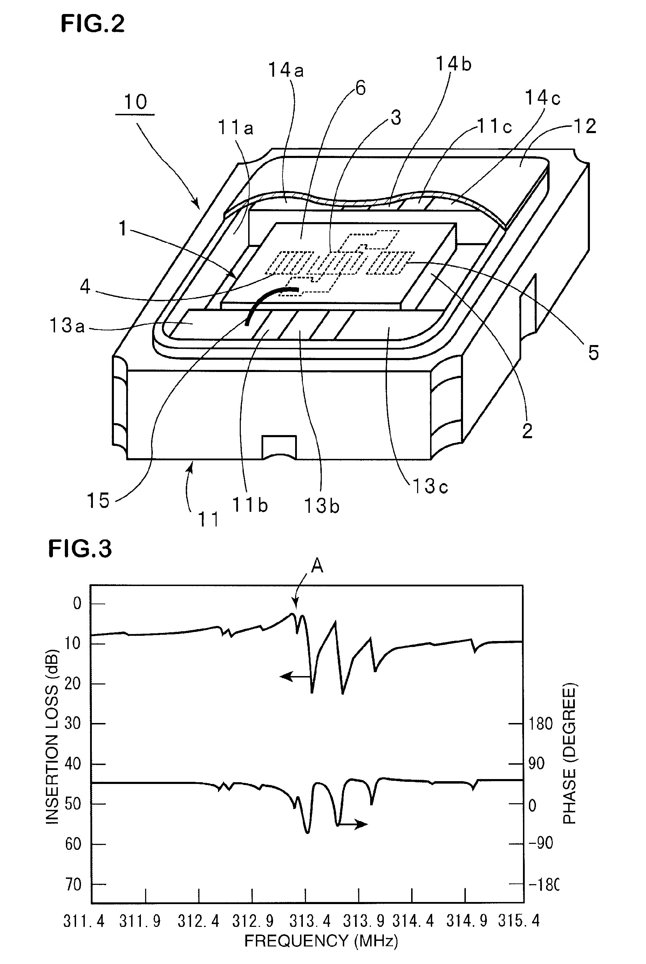

An IDT electrode 3 composed of aluminum was formed on a quartz substrate having a cut angle θ of -52°30' that serves as the quartz substrate 2. The IDT electrode 3 included 110 electrode finger pairs arranged at an aperture of 40λ and a wavelength λ of 7.635 µm. The number of electrode fingers was 45 for each of the reflectors 4 and 5. The thickness of the IDT electrode 3 and the reflectors 4 and 5 was 7.8% of the wavelength λ. The duty ratio of the IDT electrode was 0.65 and the thickness of the SiO₂ film was 40 nm. The transmission (amplitude) characteristic and the phase characteristic of a surface acoustic wave resonator of such a prepared Comparative Example, at normal temperature, i.e., 25°C, are shown in Fig. 3. As obvious from Fig. 3, a large spurious response indicated by arrow A appears between the resonance and antiresonance even at normal temperature. If such a surface acoustic wave resonator is used in an oscillation circuit, frequency jump and abnormal oscillation occur and the reliability of the oscillation circuit is impaired.

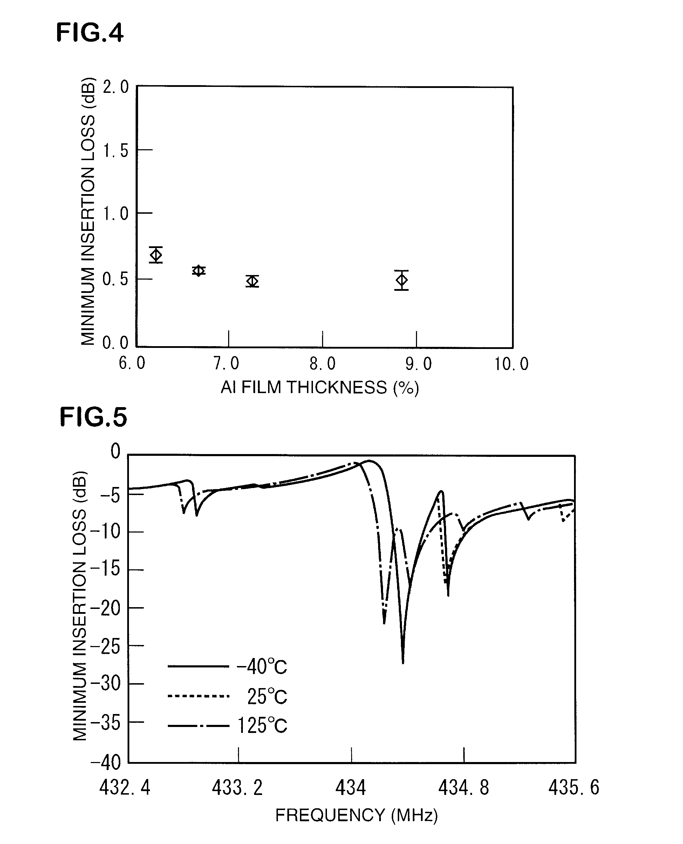

Fig. 4 is a graph showing changes in insertion loss when the thickness of the IDT electrode composed of aluminum is changed in a surface acoustic wave resonator that does not have a SiO₂ film.

As obvious from Fig. 4, when the thickness of the IDT electrode is less than 6.0% of the wavelength λ, the energy of surface waves are not sufficiently confined and the insertion loss increases. Thus, a large reflector is needed to obtain a surface acoustic wave resonator with a low loss when the thickness of the IDT electrode is less than 6% of the wavelength λ. As a result, the problem of an increase in size of the surface acoustic wave resonator arises. In order to achieve size reduction of the surface acoustic wave resonator, the thickness of the IDT electrode must be 6.0% or more of the wavelength λ.

As obvious from Fig. 4, when the thickness of the IDT electrode composed of aluminum is 6.0% or more of the wavelength λ, the insertion loss remains undegraded up to about 8.8%.

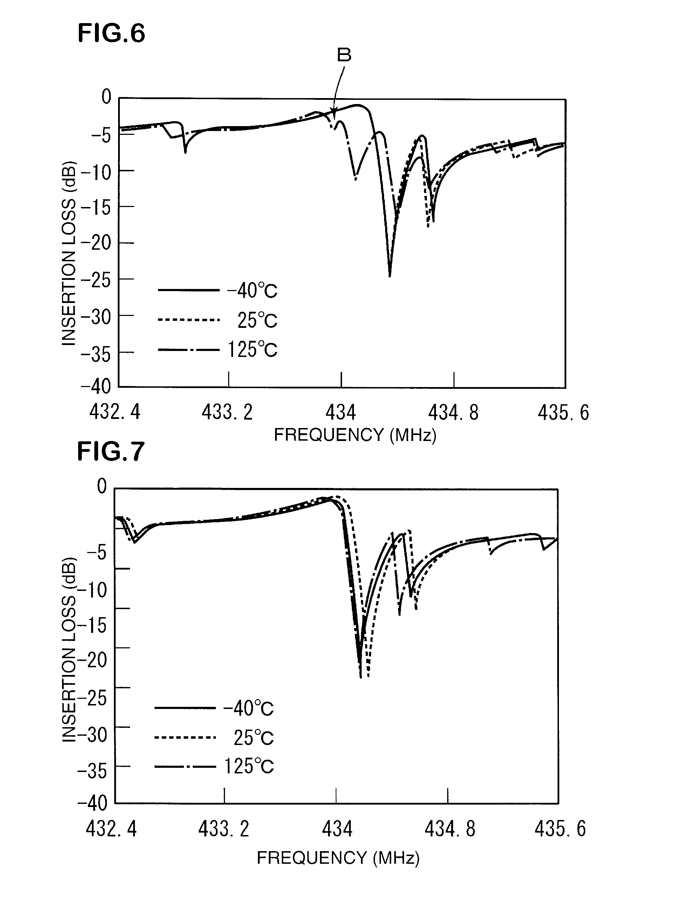

The transmission characteristic of the surface acoustic wave resonator including an IDT electrode having a thickness of 6.8% of the wavelength λ and no SiO₂ film was measured at -40°C, 25°C, and 125°C. The results are shown in Fig. 5. Next, the SiO₂ film 6 was formed to a thickness of 40 nm and the impedance characteristic thereof was measured in the same manner at -40°C, 25°C, and 125°C. The results are shown in Fig. 6.

In Figs. 5 and 6, when a broken line indicating the impedance at 25°C overlaps a solid line indicating the impedance at -40°C, the overlapping portion is indicated by a solid line.

As the comparison between Fig. 5 and Fig. 6 clearly shows, the graph in Fig. 5 in which no SiO₂ film was formed, no spurious response was observed at normal temperature (25°C) and no significant spurious response was observed at a high temperature, i.e., 125°C.

In contrast, it was newly discovered that when the SiO₂ film was formed, as obvious from Fig. 6, although spurious responses did not appear at normal temperature, a large spurious response indicated by arrow B appeared between the resonance point and the antiresonance point at a high temperature of 125°C.

Next, in a resonator having a SiO₂ film 40 nm in thickness, the thickness of the IDT electrode composed of aluminum was changed from 6.8% to 6.3% of the wavelength λ, and the transmission characteristic of the surface acoustic wave resonator was measured at -40°C, 25°C, and 125°C in a similar manner. The results are shown in Fig. 7. As obvious from Fig. 7, the spurious response at a high temperature, i.e., 125°C, could be suppressed by decreasing the thickness of the IDT electrode composed of aluminum.

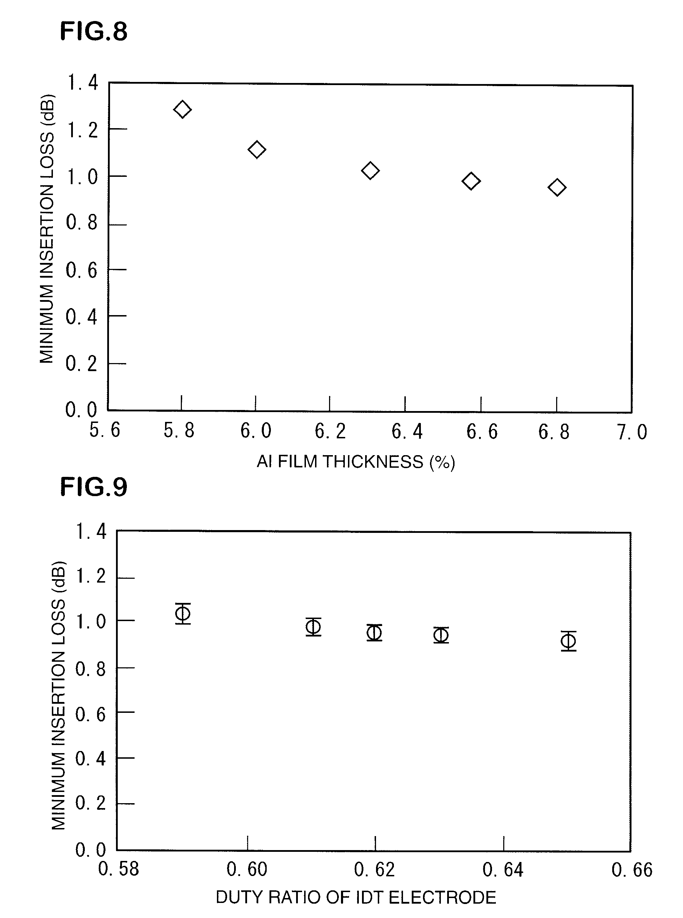

Since it appeared more preferable to decrease the thickness of the IDT electrode composed of aluminum, the thickness of the IDT electrode composed of aluminum was changed in a variety of ways, i.e., 5.8%, 6.0%, 6.3%, 6.6%, and 6.8%, and changes in insertion loss were investigated while fixing the thickness of the SiO₂ film to 40 nm. The results are shown in Fig. 8. The minimum insertion loss was also measured by setting the thickness of the IDT electrode to 6.3% of the wavelength λ and fixing the thickness of the SiO₂ film to 40 nm while varying the duty ratio of the IDT electrode in a variety of ways, i.e., 0.59, 0.61, 0.62, 0.63 and 0.65. The results are shown in Fig. 9.

As obvious from Fig. 8, the minimum insertion loss increased as the thickness of the IDT electrode decreased, indicating that a resonator once incorporated in an oscillation circuit will consume more power.

Fig. 9 shows that the increase in minimum insertion loss caused by decreasing the thickness of the IDT electrode composed of aluminum from 6.8% to 6.3%, for example, can be compensated by changing the duty ratio from 0.59 to 0.64, for example. This is because increasing the duty ratio can increase the amount of reflected surface waves per electrode finger.

Degradation of insertion loss should be suppressed while avoiding reoccurrence of spurious responses. However, in the cases where the degradation of insertion loss is suppressed by increasing the duty ratio, occurrence of a spurious response at high temperature can be suppressed. In other words, as shown in Fig. 7, when the thickness of the IDT electrode composed of aluminum is 6.3% of the wavelength λ, the spurious response at a high temperature can be effectively suppressed and degradation of insertion loss can be suppressed by increasing the duty ratio to 0.64 even in the case where the SiO₂ film is provided.

Next, the thickness of the IDT electrode composed of aluminum was set to 5.8%, 6.3%, or 6.8% of the wavelength λ and the thickness of the SiO₂ film was varied to make a plurality of types of surface acoustic wave devices. The minimum insertion losses of these plurality of types of surface acoustic wave resonators were determined. The results are shown in Fig. 10.

As obvious from Fig. 10, when the thickness of the SiO₂ film is 0, i.e., when no SiO₂ film is formed, the minimum insertion loss when the thickness of the IDT electrode composed of aluminum is 6.3% of the wavelength λ is slightly larger than the minimum insertion loss when the thickness is 6.8% of the wavelength λ. However, when the SiO₂ film is provided and the thickness of the SiO₂ film is as large as 70 nm, the minimum insertion loss is smaller when the thickness of the IDT electrode is 6.3% of the wavelength λ than when the thickness of the IDT electrode is 6.8% of the wavelength λ.

For a structure having a SiO₂ film, the thickness is preferably 20 nm or more to protect the IDT electrode with the SiO₂ film 6, as described above. In addition, as obvious from Fig. 10, when the SiO₂ film 6 is designed to be thick to some extent to suppress spurious responses at high temperature, degradation of minimum insertion loss can also be effectively suppressed. Thus, the thickness of the SiO₂ film is preferably large to some extent. According to the experiments conducted by the inventor of the present invention, as obvious from Fig. 10, for the range of 70 nm or lower, degradation of the minimum insertion loss can be effectively suppressed by adjusting the thickness of the SiO₂ film within the range of 40 nm to 70 nm. At a thickness exceeding 70 nm, the insertion loss may be degraded due to the mass of the SiO₂ film.

In the cases where the thickness of the SiO₂ film is set to 70 nm, for example, degradation of insertion loss is more suppressed when the thickness of the IDT electrode composed of aluminum is set to 6.3% of the wavelength λ than when the thickness is set to 6.8% of λ. This is because when the IDT electrode composed of aluminum is thin, the degree of concentration of the surface waves in the quartz substrate surface is low such that the surface waves are not easily affected by the disturbance at the substrate surface, e.g., the SiO₂ film.

As obvious from the experimental examples described above, the thickness of the IDT electrode composed of aluminum is preferably adjusted in the range of 6.0 to 6.5% of the wavelength λ to suppress degradation of insertion loss and spurious responses at high temperature, as shown in Figs. 7 and 8. Fig. 8 shows that the minimum insertion loss is degraded at a thickness less than 6.0%. At a thickness exceeding 6.5%, a large spurious response appeared as in the case of 6.8% shown in Fig. 6.

As shown in Fig. 9, degradation of minimum insertion loss can be suppressed by adjusting the duty ratio of the IDT electrode to 0.62 or more. At a duty ratio exceeding 0.66, formation of electrodes by photolithography becomes difficult.

In the aforementioned embodiment, the cut angle θ of the quartz substrate 2 is set to -52°30'. However, it has been confirmed that degradation of insertion loss can be suppressed as in the above-described embodiment while suppressing the spurious response at high temperature if the cut angle θ is within the range of -53° to -52°.

The surface acoustic wave resonator 1 of this embodiment is used in a surface acoustic wave device 10 shown in Fig. 2, for example. The surface acoustic wave device 10 includes a package main body 11 and a cover 12. The package main body 11 is composed of an insulating material, e.g., an insulating ceramic or synthetic resin. The surface acoustic wave resonator 1 has an opening 11a opening upward. The package main body 11 is housed inside the opening 11a and fixed to the bottom surface of the package main body 11. Steps 11b and 11c are provided at the sides of the surface acoustic wave resonator 1 inside the opening 11a. The steps 11b and 11c are lower than the upper surface of the package main body 11. Electrode lands 13a to 13c are disposed on the upper surface of the step 11b and electrode lands 14a to 14c are disposed on the upper surface of the step 11c. These electrode lands 13a to 13c and 14a to 14c are connected to the IDT electrode 3 of the surface acoustic wave resonator 1 via a bonding wire 15, for example.

The opening 11a is covered with the cover 12 to hermetically seal the surface acoustic wave resonator 1.

The cover 12 is constituted by a metal plate coated with a conductive coating such as a plating film, for example. During assembly to place the cover 12 on the opening 11a of the package main body 11, the conductive material on the surface of the cover 12 will cause a short-circuit if it is scattered by impacts or the like and land on the IDT electrode 5. According to the surface acoustic wave resonator of this embodiment, such a short-circuit is prevented because the SiO₂ film 6 is formed over the IDT electrode 5.

Moreover, the problem associated with a structure having a SiO₂ film 6, i.e., occurrence of a spurious response, whose exact cause is unknown, at a high temperature as described above, can be easily and assuredly suppressed according to the present invention. Thus, a highly reliable surface acoustic wave resonator suitable for use in a surface acoustic wave device 10 having a package structure can be provided by the present invention.

Accordingly, the surface acoustic wave resonator 1 and the surface acoustic wave device 10 of the present invention are suited for usage that may involve exposure to low temperature to high temperature of about 125°C. Examples of such usage include an oscillator of a key-less entry system for automobiles where reliability in an environment of about -40°C to +85°C is required and an oscillator of a direct tire-pressure monitoring system where reliability in the temperature range of -40°C to +125°C is required.

## Claims

1. A surface acoustic wave resonator comprising:
a rotated Y-cut quartz substrate with a cut angle θ of -53° to -52°;
an IDT electrode formed on a main surface of the quartz substrate, the IDT electrode being composed of aluminum or an alloy mainly composed of aluminum; and
a SiO₂ film covering the main surface of the quartz substrate and the IDT electrode,
wherein a propagation direction of surface acoustic waves is within the range of 90° ±5° with respect to the X axis, and
a thickness of the IDT electrode is in the range of 6.0% to 6.5% of λ, where λ is the wavelength of surface acoustic waves propagating in the quartz substrate, and a duty ratio of the IDT electrode is in the range of 0.62 to 0.66.

2. The surface acoustic wave resonator according to claim 1, wherein the thickness of the SiO₂ film is in the range of 20 to 70 nm.

3. A surface acoustic wave device comprising the surface acoustic wave resonator according to claim 1 or 2 and a packaging member housing the surface acoustic wave resonator to hermetically seal the surface acoustic wave resonator.

4. The surface acoustic wave device according to claim 2, wherein the packaging member includes a package main body having an opening in which the surface acoustic wave resonator is housed, and a cover installed to close the opening of the package main body, the surface of the cover being coated with a conductive material.
